# EUROPÄISCHE PATENTSCHRIFT

(11) **EP 0 491 712 B1**
(45) Veröffentlichungstag und Bekanntmachung des Hinweises auf die Patenterteilung: **19.01.1994**
(21) Anmeldenummer: 90911737.6
(22) Anmeldetag: 06.08.1990
(51) Int. Cl.: H03J 5/02

(54) **WETTERBALLONSONDENSENDERSYSTEM**
WEATHERBALLOON TELEMETRY TRANSMITTER SYSTEM
SYSTEME EMETTEUR TELEMETRIQUE DE BALLON-SONDE METEOROLOGIQUE

(30) Priorität: 04.09.1989 DE 3929363
(43) Veröffentlichungstag der Anmeldung: 01.07.1992
(73) Patentinhaber: FRAUNHOFER-GESELLSCHAFT ZUR FÖRDERUNG DER ANGEWANDTEN FORSCHUNG E.V., 80636 München (DE)
(72) Erfinder: HEUBERGER, Albert, Dipl.-Ing., W-8520 Erlangen (DE); GEISELBRECHT, Siegfried, Dipl.-Ing., W-8520 Erlangen (DE); SEITZER, Dieter, Dr.-Ing., W-8520 Erlangen (DE)
(74) Vertreter: Schoppe, Fritz, Dipl.-Ing.
(86) Internationale Anmeldenummer: DE9000610
(87) Internationale Veröffentlichungsnummer: WO9103873

(56) Entgegenhaltungen:
- EP-A- 0 033 390
- GB-A- 2 194 696

## Beschreibung

Die vorliegende Erfindung betrifft ein Wetterballonsondensendersystem mit einer Sendereinheit und mit einem Mikroprozessor nach dem Oberbegriff des Patentanspruchs 1.

Ein üblicher Einsatzbereich von Wetterballonsondensendern ist die Bestimmung der Temperatur, des Druckes, der Feuchtigkeit und der Geschwindigkeit von oberen Schichten der Atmosphäre für die Wettervorhersage. Zu diesem Zweck werden Wetterballonsondensender mittels Ballonsonden in diese oberen Schichten der Atmosphäre geschickt. Üblicherweise ist jeder Wetterstation eine eigene Sendefrequenz zugeordnet. Ausschließlich bei dieser bestimmten, einer jeweils einzigen Wetterstation zugeordneten Sendefrequenz darf ein Wetterballonsondensender arbeiten. Die Wetterballonsondensender, die von den Wetterstationen in der beschriebenen Art eingesetzt werden, gehen üblicherweise bei ihrem Einsatz verloren. Daher handelt es sich bei diesen Wetterballonsondensendern um in vergleichsweise hohen Stückzahlen hergestellte Produkte für den einmaligen Einsatz. Bei den heutzutage üblichen, bekannten Wetterballonsondensendern wird die Einstellung der Sendefrequenz, die vom Endabnehmer, also der betreffenden Wetterstation abhängt, beim Hersteller in unveränderlicher Weise im Laufe der Fertigung der Wetterballonsondensender vorgenommen. Da es eine sehr hohe Anzahl von Wetterstationen und dementsprechend auch eine hohe Anzahl von diesen Wetterstationen zugeordneten Sendefrequenzen gibt, führt die herstellerseitige feste Voreinstellung der Sendefrequenz zwangsläufig zu einer aufwendigen, umfangreichen Lagerhaltung an gefertigten Wetterballonsondensendern mit den verschiedenen Sendefrequenzen. Üblicherweise werden die Wetterballonsondensender vom Hersteller an eine Wetterstationenzentrale geliefert, bei der eine zentrale Lagerhaltung der Wetterballonsondensender für die einzelnen Wetterstationen vorgenommen wird. Aufgrund der oben beschriebenen Erfordernisse ergibt sich auch bei der Wetterstationenzentrale eine aufwendige, umfangreiche Lagerhaltung an Wetterballonsondensendern mit den verschiedenen Sendefrequenzen.

Aus der GB-A-2194696 ist bereits ein Sendeempfänger bekannt, der eine Sendereinheit und einen Mikroprozessor für die Steuerung eines Frequenzsynthesizers der Sendereinheit aufweist. Der Mikroprozessor umfaßt einen Festwertspeicher, in dem für jede Senderfrequenz bzw. Empfängerfrequenz eine zugeordnete Modulationsabweichungspegelinformation bzw. eine Verschiebungsinformation zum Verschieben von Oberwellen des Mikroprozessortaktes gespeichert ist, wodurch die Aufrechterhaltung eines hohen durchschnittlichen Trägermodulationspegels erreicht wird, ohne daß ein maximaler Modulationspegel überschritten wird.

Aus der EP-A-0033390 ist bereits eine Radio-Sendeempfängervorrichtung bekannt, deren Sendereinheit einen Frequenzsynthesizer mit einer automatischen Steuereinheit aufweist. Nach Eingabe der zu sendenden Frequenz mittels einer als Schalttafel bezeichneten Eingabeeinheit in die Steuereinheit wählt deren Mikroprozessor eine Betriebsart aus und steuert die verschiedenen Stufen des Frequenzsynthesizers an. Die für diese Steuerung erforderlichen Informationen sind einem Festwertspeicher des Mikroprozessors abgelegt.

Gegenüber diesem Stand der Technik liegt der vorliegenden Erfindung die Aufgabe zugrunde, ein Wetterballonsondensendersystem der eingangs genannten Art so weiterzubilden, daß der Aufwand der Lagerhaltung seitens des Herstellers oder seitens einer Anwenderzentrale erheblich vermindert wird.

Diese Aufgabe wird bei einem Wetterballonsondensender nach dem Oberbegriff des Patentanspruchs 1 durch die im kennzeichnenden Teil des Patentanspruchs 1 angegebenen Merkmale gelöst.

Die Erfindung stellt eine Abkehr von der in der Vergangenheit herrschenden Auffassung dar, daß es bei Wetterballonsondensendersystemen aus nachfolgend erläuterten Gründen unbedingt erforderlich sei, bereits seitens des Herstellers eine feste Einstellung der Sendefrequenz vorzunehmen. Bei Wetterballonsondensendern nach dem Stand der Technik stellt die Einstellung der Frequenz einen Eingriff auf die Schaltung oder die Platine dar, der schon aus Gründen der postalischen Zulassung nur durch qualifiziertes Personal seitens des Herstellers durchführbar ist. Wenn nämlich ein Laie einen Eingriff in die Schaltung vornimmt, um eine Einstellung der Sendefrequenz vorzunehmen oder abzuändern, so kann dies dazu führen, daß der Wetterballonsondensender mit einer für die Telemetrie nicht zugelassenen Sendefrequenz arbeitet.

Bei dem erfindungsgemäßen Wetterballonsondensendersystem hingegen ist eine anwenderseitige Sendefrequenzeinstellung durchführbar, die weder einen Schaltungseingriff erfordert noch die Gefahr der Einstellung einer unzulässigen Sendefrequenz mit sich bringt. Das erfindungsgemäße Wetterballonsondensendersystem hat eine Sendereinheit, die eine Frequenzsteuereinrichtung und einen von der Frequenzsteuereinrichtung gesteuerten Oszillator aufweist, wobei die Frequenzsteuereinrichtung von dem Mikroprozessor angesteuert wird. Der Mikroprozessor kann zur Einstellung der Sendefrequenz mit einer Frequenzeingabevorrichtung verbunden werden, in die eine gewünschte Sendefrequenz eingegeben werden kann. Nur dann, wenn die von der Bedienungsperson eingegebene gewünschte Sendefrequenz einer Frequenz aus einer Gruppe von vorab in der Frequenz-Eingabevorrichtung abgespeicherten zulässigen Telemetriesendefrequenzen entspricht, wird durch die Frequenzeingabevorrichtung ausgangsseitig ein Steuercode erzeugt, der dieser gewünschten und für zulässig erkannten Sendefrequenz entspricht. Diese wird von dem Mikroprozessor in einen nichtflüchtigen Speicher eingeschrieben. Der Mikroprozessor ist derart programmiert, daß bei seinem Einschalten der Steuercode aus dem nichtflüchtigen Speicher durch den Mikroprozessor ausgelesen wird und in die Frequenzsteuereinrichtung eingeschrieben wird. Hierdurch wird bei Spannungseinschaltung am Wetterballonsondensender die Einstellung der gewünschten Sendefrequenz gewährleistet.

Vorzugsweise ist der nicht-flüchtige Speicher ein elektrisch löschbarer und programmierbarer Festwertspeicher, welcher auch als EEPROM bezeichnet wird. Ein derartiger Speicher ermöglicht es nicht nur, bei der anfänglichen Eingabe der Sendefrequenz den der Sendefrequenz entsprechenden Steuercode nicht-flüchtig zu speichern, sondern ermöglicht gleichfalls ein einfaches elektrisches Löschen dieser Steuercodeinformation und eine Neuabspeicherung eines anderen, einer weiteren Sendefrequenz entsprechenden Steuercodes. Diesem Aspekt der Erfindung kommt besondere Bedeutung insbesondere für den Fall zu, daß ein Wetterballonsondensender nach seinem Einsatz durch eine bestimmte Wetterstation wiedergefunden wird und dessen Einsatz durch eine andere Wetterstation anschließend gewünscht wird, welcher jedoch eine andere Sendefrequenz der Wetterballonsondensender zugeordnet ist.

Vorzugsweise umfaßt die Frequenzsteuereinrichtung eine PLL-Steuerschaltung bzw. eine Steuerschaltung für eine phasenstarre Regelschleife, wobei in diesem Fall der Steuercode der der gewünschten Sendefrequenz entsprechenden Teileeinstellung der PLL-Steuerschaltung entspricht. In diesem Fall können handelsübliche PLL-Steuerschaltungen mit handelsüblichen, zugeordneten spannungsgesteuerten Oszillatoren für die Zwecke der vorliegenden Erfindung verwendet werden.

Weiterbildungen der PLL-Steuerschaltung und des Oszillators des erfindungsgemäßen Wetterballonsondensendersystemes sind Gegenstand der Unteransprüche 4 und 5.

Nachfolgend wird unter Bezugnahme auf die einzige, beiliegende Figur eine Ausführungsform des erfindungsgemäßen Wetterballonsondensendersystemes näher erläutert. Es zeigen:

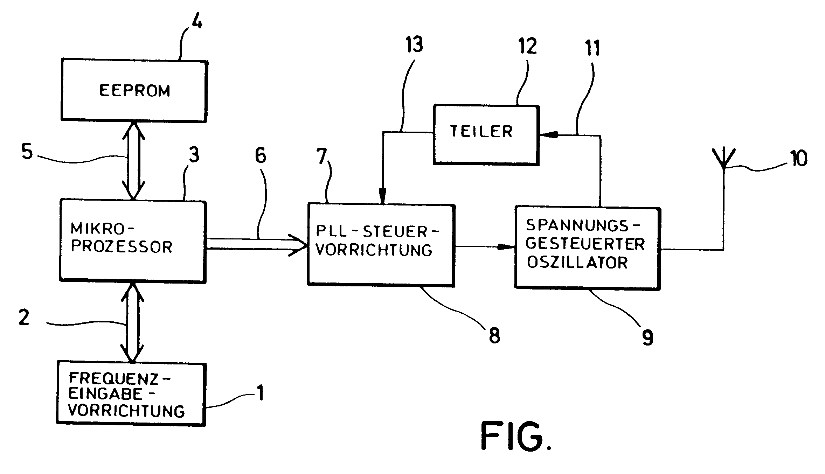

Die einzige Figur ein Blockschaltbild einer Ausführungsform des erfindungsgemäßen Wetterballonsondensendersystemes.

Das in der Figur in seiner Gesamtheit dargestellte Wetterballonsondensendersystem umfaßt im wesentlichen eine Frequenzeingabevorrichtung 1, die über einen seriellen Datenbus 2 mit einem Wetterballonsondensender 3 bis 10 verbindbar ist.

Der Wetterballonsondensender umfaßt einen Mikroprozessor 3, der mit einem elektrisch löschbaren und programmierbaren Festwertspeicher bzw. EEPROM 4 über einen ersten Datenbus 5 und mit einer PLL-Steuervorrichtung 7 über einen zweiten Bus 6 verbunden ist. Die PLL-Steuervorrichtung 7 ist mit einer Steuerleitung 8 an den Spannungssteuereingang eines spannungsgesteuerten Oszillators 9 angeschlossen, der ausgangsseitig mit einer Sendeantenne 10 verbunden ist. Eine Rückkoppelungsleitung 11 führt von einem Frequenzausgang des spannungsgesteuerten Oszillators 9 über einen Teiler 12 zu einer Rückkoppelungseingangsleitung 13 der PLL-Steuervorrichtung 7.

Nach Eingabe einer gewünschten Sendefrequenz bzw. eines Kanales durch eine Bedienungsperson in die Frequenzeingabevorrichtung 1 wird zunächst durch die Frequenzeingabevorrichtung 1 festgestellt, ob die gewünschte Sendefrequenz einer Frequenz aus einer Gruppe von vorab in der Frequenzeingabevorrichtung 1 abgespeicherten, zulässigen Telemetriesendefrequenzen entspricht. Falls dies der Fall ist, berechnet die Frequenzeingabevorrichtung 1 den dieser für zulässig erkannten, gewünschten Sendefrequenz entsprechenden Steuercode, der Teilereinstellung der PLL-Steuervorrichtung 7 für diese Sendefrequenz entspricht. Dieser Steuercode wird von der Frequenzeingabevorrichtung 1, die durch einen Personalcomputer gebildet sein kann, über den seriellen Datenbus dem Mikroprozessor 3 zugeführt, der den Steuercode in dem EEPROM 4 einspeichert. Nunmehr wird der Wetterballonsondensender 3 bis 10 von der Frequenzeingabevorrichtung 1 getrennt.

In dem beschriebenen Zustand ist der Wetterballonsondensender 3 bis 10 frequenzmäßig eingestellt.

Wenn anschließend die Betriebsspannung des Wetterballonsondensenders 3 bis 10 eingeschaltet wird, so wird der Mikroprozessor 3 durch eine geeignete Programmierung dazu veranlaßt, den Steuercode aus dem EEPROM 4 auszulesen und in die PLLSteuervorrichtung 7 einzuschreiben. Damit sind die dem Steuercode entsprechenden Teilerverhältnisse für die PLLSteuervorrichtung 7 bei jedem Einschalten der Betriebsspannung des Wetterballonsondensenders festgelegt.

Als Mikroprozessor 3 eignet sich ein Mikroprozessor, der von der Firma "INTEL" unter der Bezeichnung 80C31 angeboten wird. Als EEPROM 4 kommt ein EEPROM in Betracht, das eine serielle Speicherung von 256 Byte erlaubt.

Die PLL-Steuervorrichtung 7 kann beispielsweise eine Schaltung sein, wie sie von der Firma Fujitsu unter der Bezeichnung MB87006 angeboten wird.

## Patentansprüche

1. Wetterballonsondensendersystem zur Übertragung von für die Wettervorhersage erforderlichen Meßdaten der Atmosphäre zu einer bestimmten aus einer Mehrzahl von Wetterstationen, mit einer Sendereinheit und mit einem Mikroprozessor,
dadurch gekennzeichnet,
daß die Sendereinheit (7 - 13) eine Frequenzsteuereinrichtung (7), die mit dem Mikroprozessor (3) verbunden ist, und einen von der Frequenzsteuereinrichtung (7) gesteuerten Oszillator (9) aufweist,
daß der Mikroprozessor (3) mit einer Frequenzeingabevorrichtung (1) verbindbar ist, in die eine gewünschte Sendefrequenz eingebbar ist, und die nur dann, wenn die gewünschte Sendefrequenz einer Frequenz aus einer Gruppe von vorab in der Frequenzeingabevorrichtung (1) abgespeicherten zulässigen Sendefrequenzen entspricht, von denen je eine einer bestimmten Wetterstation zugeordnet ist, einen dieser gewünschten Sendefrequenzen korrespondierenden Steuercode für die Frequenzsteuereinrichtung (7) erzeugt,
daß ein nicht-flüchtiger Speicher (4) mit dem Mikroprozessor (3) verbunden ist, in den der Mikroprozessor (3) den Steuercode von der Frequenzeingabevorrichtung (1) ablegt, und
daß der Mikroprozessor (3) derart programmiert ist, daß er jedes Mal dann, wenn er eingeschaltet wird, den Steuercode aus dem nicht-flüchtigen Speicher (4) ausliest und der Frequenzsteuereinrichtung (7) zuführt.

2. Wetterballonsondensendersystem nach Anspruch 1, dadurch gekennzeichnet,
daß der nicht-fIüchtige Speicher ein elektrisch löschbarer und programmierbarer Festwertspeicher (4) (EEPROM) ist.

3. Wetterballonsondensendersystem nach Anspruch 1 oder 2, dadurch gekennzeichnet,
daß die Frequenzsteuereinrichtung eine PLL-Steuerschaltung ist, und
daß der Steuercode die der gewünschten Sendefrequenz korrespondierenden Teilereinstellungen der PLL-Steuerschaltung (7) umfaßt.

4. Wetterballonsondensendersystem nach Anspruch 3, dadurch gekennzeichnet,
daß die PLL-Steuerschaltung (7) ausgangsseitig eine Abstimmspannung entsprechend der Teilereinstellung erzeugt, und
daß der Oszillator ein spannungsgesteuerter Oszillator (9) ist, dessen Steuereingang die Abstimmspannung zuführbar ist.

5. Wetterballonsondensendersystem nach Anspruch 4, dadurch gekennzeichnet,
daß der spannungsgesteuerte Oszillator (9) ausgangsseitig über eine Teilerschaltung (12) mit einem Rückkopplungseingang (13) der PLL-Steuerschaltung (7) verbunden ist.

## Claims

1. A weatherballoon sonde telemetry transmitter system for transmitting measurement data of the atmosphere which are required for weather forecasts to a specific one of a plurality of weather stations, comprising a transmitter unit and a microprocessor,
characterized in
that the transmitter unit (7 - 13) includes a frequency-control device (7), which is connected to the microprocessor (3), and an oscillator (9) controlled by said frequency-control device (7),
that the microprocessor (3) is adapted to be connected to a frequency-input device (1), said frequency-input device (1) being adapted to have inputted therein a desired transmit frequency and generating a control code, which is used for the frequency-control device (7) and which corresponds to this desired transmit frequency, only if the desired transmit frequency corresponds to a frequency of a group of permitted transmit frequencies stored in advance in said frequency-input device (1), each of said permitted transmit frequencies being associated with a specific weather station,
that a non-volatile memory (4) is connected to the microprocessor (3), said microprocessor (3) storing the control code from the frequency-input device (1) in said non-volatile memory (4), and
that the microprocessor (3) is programmed in such a way that, whenever switched on, it will read the control code out of the non-volatile memory (4) and feed it to the frequency-control device (7).

2. A weatherballoon sonde telemetry transmitter system according to claim 1, characterized in
that the non-volatile memory is an electrically erasable and programmable read-only memory (4) (EEPROM).

3. A weatherballoon sonde telemetry transmitter system according to claim 1 or 2, characterized in
that the frequency-control device is a PLL control circuit, and
that the control code includes the divider settings of the PLL control circuit (7) which correspond to the desired transmit frequency.

4. A weatherballoon sonde telemetry transmitter system according to claim 3, characterized in
that the PLL control circuit (7) generates on the output side a tuning voltage corresponding to the divider setting, and
that the oscillator is a voltage-controlled oscillator (9) whose control input is adapted to have supplied thereto said tuning voltage.

5. A weatherballoon sonde telemetry transmitter system according to claim 4, characterized in
that the output side of the voltage-controlled oscillator (9) is connected to a feedback input (13) of the PLL control circuit (7) via a divider circuit (12).

## Revendications

1. Système émetteur télémétrique de ballon-sonde météorologique pour la transmission des données de mesure de l'atmosphère nécessaires pour la prévision météorologique à l'une déterminée d'une pluralité de stations météorologiques, comprenant une unité émettrice et un micro-processeur, caractérisé en ce
que l'unité émettrice (7 - 13) présente un dispositif de commande de fréquence (7) relié au micro-processeur (3) et un oscillateur (9) commandé par le dispositif de commande de fréquence (7),
que le micro-processeur (3) peut être relié à un dispositif d'entrée de fréquence (1) dans lequel peut être entrée une fréquence d'émission souhaitée et qui ne genère de code de commande pour le dispositif de commande de fréquence (7) que lorsque la fréquence d'émission souhaitée correspond à une fréquence parmi un groupe de fréquences d'émission admissibles préalablement mémorisées dans le dispositif d'entrée de fréquence (1) qui sont attribuées chacune à une station météorologique déterminée,
qu'une mémoire (4) non-fuyante est reliée au micro-processeur, dans laquelle le micro-processeur enregistre le code de commande du dispositif d'entrée de fréquence (1), et
que le micro-processeur (3) est programmé de manière qu'il lit, chaque fois qu'il est enclenché, le code de commande de la mémoire (4) non-fuyante et l'alimente vers le dispositif de commande de fréquence (7).

2. Système émetteur télémétrique de ballon-sonde météorologique suivant la revendication 1, caractérisé en ce que la mémoire non-fuyante est une mémoire de valeur fixe (4) programmable et déclenchable électriquement (EEPROM).

3. Système émetteur télémétrique de ballon-sonde météorologique suivant la revendication 1 ou 2, caractérisé en ce
que le dispositif de commande de fréquence est un circuit de commande PLL, et
que le code de commande comprend les réglages du diviseur du circuit de commande PLL (7) correspondant à la fréquence d'émission souhaitée.

4. Système émetteur télémétrique de ballon-sonde météorologique suivant la revendication 3, caractérisé en ce
que le circuit de commande PLL (7) produit, du coté sortie, une tension de réglage correspond au réglage du diviseur, et
que l'oscillateur est un oscillateur (9) commandé par la tension, à l'entrée de commande duquel peut être amenée la tension de réglage.

5. Système émetteur télémétrique de ballon-sonde météorologique suivant la revendication 4, caractérisé en ce que l'oscillateur (9) commandé par la tension est relié, du côté sortie, à une entrée de couplage de réaction (13) du circuit de commande PLL (7), par l'intermédiaire d'un circuit diviseur (12).
